(19) Europäisches Patentamt

European Patent Office

Office européen des brevets

(11) EP 0 981 198 A2

## (12) EUROPEAN PATENT APPLICATION

(43) Date of publication:
23.02.2000 Bulletin 2000/08

(51) Int Cl.$^7$: H03G 1/00

(21) Application number: 99402082.4

(22) Date of filing: 18.08.1999

(84) Designated Contracting States:
AT BE CH CY DE DK ES FI FR GB GR IE IT LI LU MC NL PT SE
Designated Extension States:
AL LT LV MK RO SI

(30) Priority: 19.08.1998 US 136475

(71) Applicant: HARRIS CORPORATION
Melbourne Florida 32912 (US)

(72) Inventor: Borodulin, Dmitryi
Quincy, Illinois (US)

(74) Representative: Ballot, Paul Denis Jacques et al
Cabinet Ballot-Schmit,
7, rue Le Sueur
75116 Paris (FR)

## (54) Improved signal detector

(57)    A circuit is presented for providing an indication of the RMS value of a frequency signal. This includes first and second signal translating circuits for receiving a frequency signal. Each translating circuit exhibits a different response time constant in responding to the frequency signal. A differential circuit is coupled to receive the first and second output signals from the outputs of the first and second signal translating circuits in order to provide an output signal. A feedback circuit is coupled between the output of the differential circuit and one of the outputs of the first and second translating circuits.

Fig.1

## Description

The present invention is directed to detectors for providing an indication of the average value of a frequency signal.

During the operation of an amplifier, it is frequently desirable to sample the level of the input signal and the level of the output signal as well as the level of any reflected power. These samples may be used to provide control of the amplifier.

Circuit designers have, in the past, used true RMS detectors for converting an input baseband signal into a DC level proportional to the RMS power. Such circuits have been commercially available as integrated circuits. Thus far, they have been suitable only for use at low frequencies, such as up to 10kHz. Consequently, they are not able to provide an RMS signal representative of a baseband signal of a high frequency, such as 6MHz wide as in the case of television signals. It is desirable to provide an economical circuit that will provide an output voltage that is proportional to the RMS value of an input voltage without employing complex circuitry.

The present invention includes a circuit for providing an indication of the RMS value of a frequency signal comprising first and second signal translating circuits for receiving a frequency signal, said signal translating circuits exhibiting different response time constants in responding to the frequency signal applied thereto, a differential circuit coupled to receive first and second signals from the outputs of the first and second signal translating circuits to provide an output signal, characterized in that a feedback circuit coupled between the output of the differential circuit and one of outputs of the first and second signal translating circuits so that as the signal rises at the output of the other signal translating circuit the output signal of the differential circuit follows the rising signal and when the signal decreases at the output of the other signal translating circuit the output signal of the differential circuit follows the signal output of the signal translating circuit to which the feedback circuit is coupled.

The invention also includes a method of providing a signal representative of the RMS value of a modulated radio frequency signal comprising characterized by applying the frequency signal to first and second signal translating circuits having different time constants for responding to the frequency signals, and monitoring the outputs of the first and second signal translating circuits to provide an output signal that follows the output signal of the first signal translating circuit when the magnitude of the output signal is rising and following the output signal of the second translating circuit when the magnitude of the output signal of the first signal translating circuit is falling to provide an output signal that is representative of the value of the frequency signal.

Conveniently, a circuit is presented for providing an indication of the average value of a frequency signal. This includes first and second signal translating circuits for receiving a frequency signal. Each translating circuit exhibits a different response time constant in responding to the frequency signal. A differential circuit is coupled to receive the first and second output signals from the outputs of the first and second signal translating circuits in order to provide an output signal. A feedback circuit is coupled between the output of the differential circuit and one of the outputs of the first and second translating circuits. The output signal of the differential circuit is representative of the average value of the frequency signal.

The invention will now be described, by way of example, with reference to the accompanying drawings, in which:

Fig. 1 is a schematic-block diagram illustration of a power amplifier which may employ one embodiment of the invention;
Fig. 2 is a block diagram of a power detector; and,
Fig. 3 is a schematic-block diagram of an RMS detector in accordance with the invention.

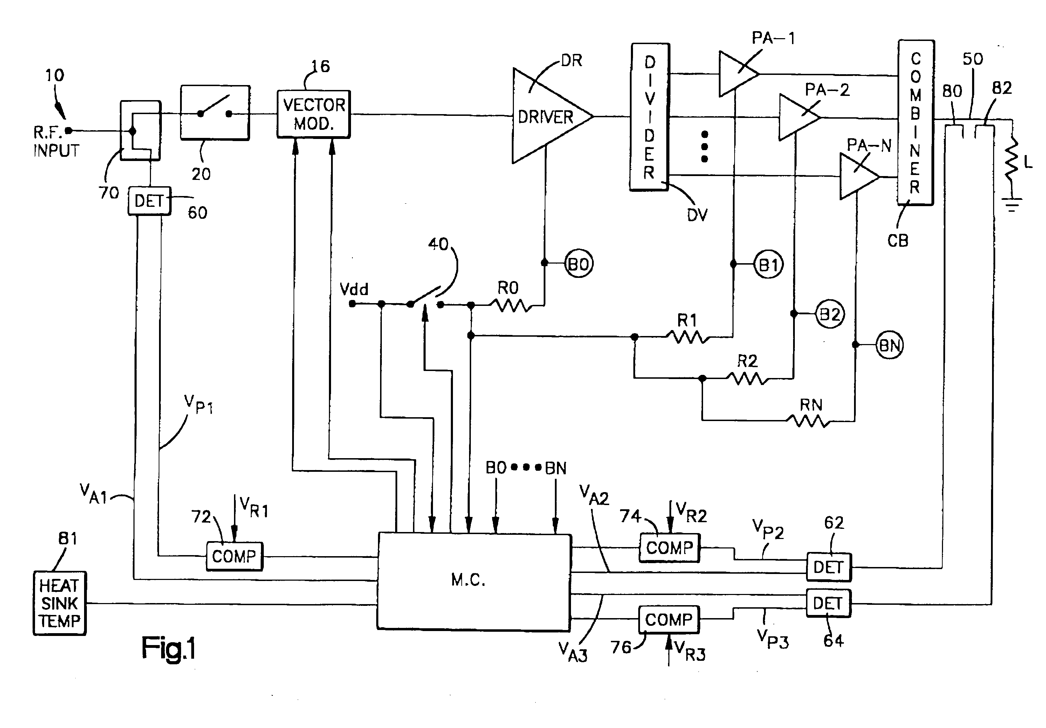

Fig. 1 illustrates a power amplifier module or system which receives a modulated RF input signal at an input terminal 10 and amplifies the signal and supplies it to a load L, which may take the form of a transmitting antenna and associated equipment. As an example only, the RF input signal may have a magnitude on the order of 20 milliwatts and have a frequency within the UHF frequency range between 470 and 860 MHz with a 6 MHz bandwidth for the television channel involved. The signal may be increased by the amplifier with a gain on the order of 43 dB so that the output signal as applied to the load L may be on the order of 400 watts.

The RF input signal is applied to the input terminal 10 and, thence, to a vector modulator. The vector modulator changes the magnitude and the phase of the RF signal. The modified RF signal from the vector modulator is then amplified by a driver DR to a higher level, such as 20 watts. The output, as taken from the driver DR, is then supplied to a power divider DV, sometimes referred to as a signal or power splitter, which divides the amplified signal by a factor of N. N signals are then applied to N power amplifiers PA-1 through PA-N, where N, for example, may be 12. The signals from the power amplifiers PA-1 through PA-N are then combined in a signal combiner CB to provide an output signal which is applied to the load L.

The input signal is applied to a vector modulator 16 when the RF input switch 20 is closed. The RF switch 20 is controlled by a microcontroller MC, as will be explained in greater detail hereinafter. The microcontroller also controls the vector modulator to vary the phase and gain of the RF signal.

The driver DR amplifies the signal with a gain of approximately 14 dB to deliver an RF signal of approximately 20 watts to a divider DV. This divider serves as a power splitter and splits the applied RF signal into N portions. The divider applies N equal portions of the RF signal to respective power amplifiers PA-1 through PA-N. Each power amplifier includes a field effect transistor having its drain electrode connected through a suitable resistor, such as resistor R1 or R2 or RN, to a DC switch 40. When this switch is closed, it connects each drain electrode with a DC voltage source $V_{DD}$. This voltage source may, for example, be on the order of 32 volts.

The outputs from the power amplifiers PA-1 through PA-N are combined at the power combiner CB. The output signal at the output circuit 50 is on the order of 400 watts.

The microcontroller MC monitors the operation of the amplifier system and controls the system by varying the phase and or gain of the RF signal and controlling the operation of the RF switch 20 and the DC switch 40.

When the DC switch 40 is closed, current will flow in the power amplifiers PA-1 through PA-N. This current will flow through the associated resistors R1 through RN. A voltage is developed across each resistor. These voltages are supplied as current samples to the microprocessor MC which then determines whether the current levels are too high or too low and takes appropriate action. Also, when the switch 40 is dosed current flows through resistor R0 and the driver DR. The voltage developed across this resistor is also supplied to the microcontroller MC for analysis.

In addition to monitoring the current flowing through the various power amplifiers, the microcontroller also monitors peak and average power levels with the use of power detectors. These detectors include an input power detector 60 and output power detectors 62 and 64. The power detector 60 is connected to an input signal divider 70 and serves to provide DC output signals $V_{P1}$ and $V_{A1}$ respectively representative of the input peak power and the input average power. The signal representative of the input peak power $V_{P1}$ is compared with a reference $V_{R1}$ at comparator 72. If the peak power $V_{P1}$ exceeds the reference then an interrupt signal is supplied to the microprocessor MC which interrupts the routine being processed and enters a fault process to turn the power amplifier system off.

Detector 62 is connected to a incident signal coupler 80 coupled to the output transmission line 50. This detector 62 provides a DC voltage signal $V_{P2}$ representative of the peak output power as well as a DC voltage $V_{A2}$ which represents the average output power in the forward direction at the output transmission line 50. Signal $V_{P2}$ is compared with a reference $V_{R2}$ at comparator 74. If signal $V_{P2}$ exceeds reference $V_{R2}$ then an interrupt signal is supplied to microcontroller MC which then enters a fault process routine to turn the power amplifier off

A coupler 82 is employed for sensing the reflected power and this coupler is connected to detector 64. This detector 64 serves to provide DC voltage signals including a signal $V_{P3}$ representative of the peak reflected power and $V_{A3}$ representative of the average reflected power. If signal $V_{P3}$ exceeds a reference $V_{R3,}$ then comparator 76 applies an interrupt signal to the microcontroller MC which then enters a fault process routine to turn the power amplifier off. The monitored average power signals $V_{A1}$, $V_{A2}$ and $V_{A3}$ are supplied to the microcontroller MC which is programmed to vary the gain and/or phase of the RF signal as needed.

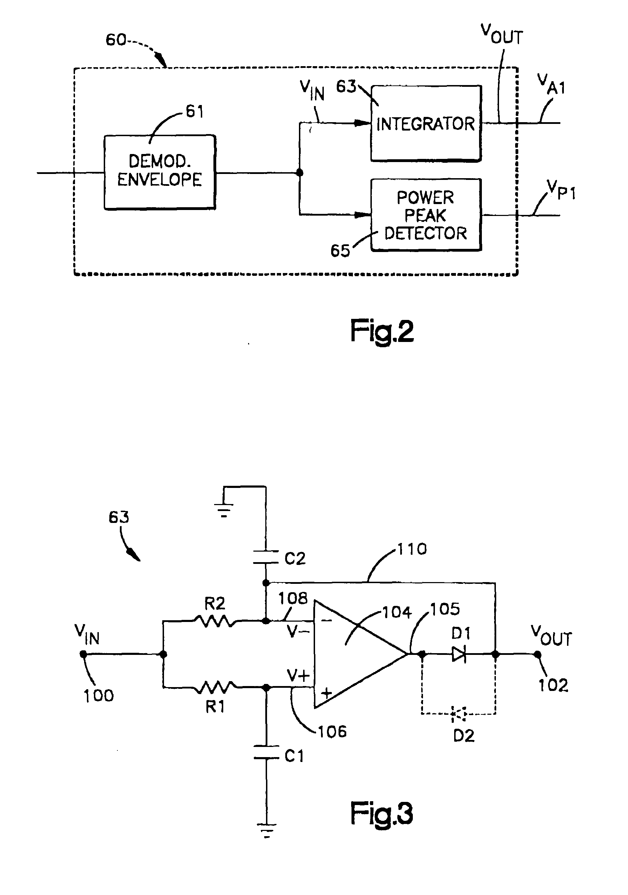

Each of the power detectors is constructed in the same fashion as detector 60 which is described in detail with reference to Fig. 2. This detector includes an envelope demodulator 61 which receives a sample of an RF signal from correspondingly input or output transmission lines. The carrier signal may, for example, be on the order of 600 MHz and the baseband for the television signal has a bandwidth of 6 MHz. The demodulator 61 effectively strips off the carrier signal (600 MHz) leaving only the demodulated baseband signal. This signal may be viewed as an analog positive signal and which is applied to the integrator 63 and a peak power detector 65.

The integrator 63 provides an output signal in the form of voltage $V_{A1}$ representative of the average input power whereas the peak detector 65 provides an output signal in the form of a voltage $V_{P1}$ representative of the peak input power. The demodulator 61 and the integrator 63 form an RMS detector.

The integrator 63 located in each of the detectors 60, 62 and 64 may take the form as illustrated in Fig. 3 to be described below.

As will be recalled, the digital 8-VSB format refers to an 8 level vestigial sideband signal. The baseband of this signal is 6 MHz wide. It is desired to provide efficient power level control of the power amplifier system illustrated in Fig. 1. To achieve this, it is desirous to provide a power detector that provides an output signal, $V_{out}$ which is proportional to the corresponding average power. In the past, circuit designers have typically employed true RMS detectors for converting an input baseband signal into a DC level proportional to the RMS power. This is done in accordance with the equation noted below.

$$V_{RMS} = \frac{\sqrt{\int_0^T V_{in}^2 dt}}{T}$$

A significant problem in a power amplifier system as shown in Fig. 1 is the complexity and expense of the circuitry to perform the above equation. At present, commercially available integrated circuits that perform this type of an equation are only suitable for use at low frequencies, such as up to 10 kHz. As such, they are not able to provide an RMS signal representative of a baseband signal that is of a substantially higher frequency, such as being 6 MHz wide as in the case of digital television signals. There is a need to provide a circuit that will deliver an output voltage $V_{out}$ which is proportional to the RMS value of the input voltage $V_{in}$ without employing multiplication (such as $V_{in}$ times $V_{in}$ to obtain $V_{in}^2$). This can be achieved for certain types of signals such as any periodic signals or stochastic signals. In other words, for signals which frequency spectrum does not change over time. The examples are: 8-VSB, COFDM modulated signals. This is achieved with the circuit shown in Fig. 3 as described below.

The input voltage $V_{in}$, which is an amplitude envelope of modulated RF signal with the characteristics as described above, is applied to an input terminal 100 and the output voltage $V_{out}$ is obtained at an output terminal 102. A wideband operational amplifier 104 is provided having an RC charge path connected to its positive or non-inverting input 106 and an RC discharge path is connected to its inverting or negative input 108. The charge path includes a resistor R1 and a capacitor CI having their junction point connected to input 106 of amplifier 104. The other side of capacitor C1 is connected to circuit ground. The discharge path includes a resistor R2 and a capacitor C2 having their junction point connected to input 108 of the operational amplifier 104. The other side of capacitor C2 is connected to circuit ground. A diode D1 is connected between the output 105 of amplifier 104 and the circuit output 102. The circuit output 102 is connected to the negative input 108 of the amplifier 104 by way of a circuit path 110.

The circuit in Fig. 3 has separate RC circuits that define the charge and discharge time constants and thereby provides independently controlled charge and discharge times. The circuit may be tuned by changing the value of resistors R1 and R2 so that the ratio of the charge and discharge time constants allows the detector to deliver an output voltage $V_{out}$ proportional to the RMS value of $V_{in}$. The manner of operation involved is presented below. Consider a situation wherein the diode D1 is connected between output 105 and circuit output 102 and that $R2 \cdot C2 \geq R1 \cdot C1$.

In this situation, the voltages $V_{out}$ and V- will follow voltage V+ as voltage V+ increasus. The moment voltage V+ decreases, voltage $V_{out}$ follows the discharge time $R2 \cdot C2$ until V+ increases again and the operation repeats. Since voltage V+ follows voltage $V_{in}$ with a charge time constant $R1 \cdot C1$, then voltage $V_{out}$ follows voltage $V_{in}$ with the $C1 \cdot R1$ time constant on the rise and the $C2 \cdot R2$ time constant on the voltage $V_{in}$ fall.

When the $R2 \cdot C2$ time constant is long enough ($\frac{1}{C2 \cdot R2} < f_{low}$ where $f_{low}$ is the lowest frequency in the spectrum of the envelope demodulated signal) this allows creation of the voltage $V_{out}$ anywhere in the range from voltage $V_{in}$ max. to voltage $V_{in}$ average by manipulating the $C1 \cdot R1$ time constant from $C1 \cdot R1=0$ to $C1 \cdot R1=C2 \cdot R2$.

If the diode D1 is replaced by diode D2 (as shown by the broken line) the condition $R1 \cdot C1 \geq R2 \cdot C2$ results. If $R1 \cdot C1$ is long enough ($\frac{1}{C1 \cdot R1} < f_{low}$) then this allows creation of voltage $V_{out}$ anywhere in the range from $V_{in}$ average to $V_{in}$ minimum, varying $C2 \cdot R2$ from = $C1 \cdot R1$ to zero.

In the power amplifier system of Fig. 1, it is contemplated that an 8-VSB baseband signal is involved. It's spectrum looks like white noise with a frequency range from 0 to 6 MHz and almost even distribution of power within the range. The goal is to tune the ratio of charge and discharge time constants for the detector to deliver voltage $V_{out}$ proportional to the RMS value of voltage $V_{in}$ without going through a multiplication ($V_{in} \cdot V_{in}$), which would require circuit complication.

This is achieved by referencing voltage $V_{out}$ originated by 8-VSB modulated RF to voltage $V_{out}$ originated by CW. Since the modulation baseband of the nonmodulated (CW)RF signal is equal to zero, voltage $V_{in}$ is a DC voltage. The RMS value for the DC voltage is equal to the voltage itself. Applied as voltage $V_{in}$ it will appear as $V_{out}=V_{in}$ on the output of the detector. The level of this voltage $V_{out}$ can be used as a reference of RMS voltage for a given average power of RF and, after switching from CW to 8-VSB signal with the same average power level, tune the time constants so that the voltage $V_{out}$ shows the same value.

The way to tune the time constants is to adjust the values of resistors R1 and R2 to achieve a certain voltage $V_{out}$, Thus, the RMS detector delivers true RMS value for two kinds of RF modulations: CW (no modulation) and 8-VSB.

Another explanation that may be employed for understanding the circuitry of Fig. 3 is now presented. A non-modulated continuous wave (CW) signal of a known power level $P_r$ may be applied to the RF input terminal 10 (see Fig. 1). The value of voltage $V_{out}$, is observed. The continuous wave may then be replaced with an 8-VSB source of the same known power level $P_r$. Again, the output voltage $V_{out}$ is observed. Since the input power levels were the same $P_r$, the value of voltage $V_{out}$ should be the same for both cases. If it is not the same, then the values of resistor R1 and R2 in the charge and discharge paths, are varied to change the ratio of the charge and discharge time constants. Once the output voltages are the same then the values of the resistors are fixed and thus they have been optimized to achieve the same voltage $V_{out}$ for both CW and 8-VSB baseband signals.

A circuit is presented for providing an indication of the RMS value of a frequency signal. This includes first and second signal translating circuits for receiving a frequency signal. Each translating circuit exhibits a different response time constant in responding to the frequency signal. A differential circuit is coupled to receive the first and second output signals from the outputs of the first and second signal translating circuits in order to provide an output signal. A feedback circuit is coupled between the output of the differential circuit and one of the outputs of the first and second translating circuits.

## Claims

1. A circuit for providing an indication of the RMS value of a frequency signal comprising first and second signal translating circuits for receiving a frequency signal, said signal translating circuits exhibiting different response time constants in responding to the frequency signal applied thereto, a differential circuit coupled to receive first and second signals from the outputs of the first and second signal translating circuits to provide an output signal, characterized in that a feedback circuit coupled between the output of the differential circuit and one of outputs of the first and second signal translating circuits so that as the signal rises at the output of the other signal translating circuit the output signal of the differential circuit follows the rising signal and when the signal decreases at the output of the other signal translating circuit the output signal of the differential circuit follows the signal output of the signal translating circuit to which the feedback circuit is coupled.

2. A circuit as claimed in claim 1 characterized in that the values of the time constants of the first and second signal translating circuits are set so that the magnitude of the output signal of the differential circuit is approximately the same for frequency signals having CW modulation and having DTV modulation, in which the first and second signal translating circuits are comprised of resistor capacitor circuits and the frequency signals are applied to the resistors and each junction of a resistor and a capacitor is coupled to the input of the differential circuit.

3. A circuit as claimed in claim 2 wherein the differential circuit is a differential amplifier and the outputs of the first and second signal translating circuits are coupled to separate inverting and non-inverting input circuits of the differential amplifier, and wherein the feedback circuit is coupled to the inverting input circuit.

4. A circuit as claimed in claim 3 wherein the value of the time constant of the signal translating circuit coupled to the inverting input of the differential amplifier is greater than the time constant of the other signal translating circuit.

5. A circuit as claimed in claim 3 wherein the value of the time constant of the signal translating circuit coupled to the non-inverting input of the differential amplifier is greater than the time constant of the other signal translating circuit.

6. A method of providing a signal representative of the RMS value of a modulated radio frequency signal comprising characterized by applying the frequency signal to first and second signal translating circuits having different time constants for responding to the frequency signals, and monitoring the outputs of the first and second signal translating circuits to provide an output signal that follows the output signal of the first signal translating circuit when the magnitude of the output signal is rising and following the output signal of the second translating circuit when the magnitude of the output signal of the first signal translating circuit is falling to provide an output signal that is representative of the value of the frequency signal.

7. A method as claimed in claim 6 including setting the time constant of the second translating circuit so that it is long compared to the frequency of the frequency signal, setting the time constant of the first signal translating circuit with an unmodulated frequency signal, and re-setting the time constant of the first signal translating circuit with a modulated frequency signal.

Fig.1

EP 0 981 198 A2

Fig.2

Fig.3